# EUROPEAN PATENT APPLICATION

(11) **EP 4 481 809 A1**
(43) Date of publication of application: **25.12.2024**
(21) Application number: 23213610.1
(22) Date of filing: 01.12.2023
(51) Int. Cl.: H01L 23/498, H01L 23/64, H01L 23/15

(54) **GLASS LAYERS AND CAPACITORS FOR USE WITH INTEGRATED CIRCUIT PACKAGES**

(30) Priority: 22.06.2023 US 202318339685
(71) Applicant: INTEL Corporation, Santa Clara, CA 95054 (US)
(72) Inventor: Waidhas, Bernd, 93186 Pettendorf (DE); Wagner, Thomas, 91189 Regelsbach (DE); Seidemann, Georg, 84036 Landshut (DE); Richaud, Nicolas, 00157 Rome (IT); Dutta, Manisha, 81549 Munich (DE); Dogiamis, Georgios, Chandler, 85226 (US); Dhakad, Harshit, 560066 Bangalore (IN); Langenbuch, Michael, 81825 Munich (DE)
(74) Representative: Goddar, Heinz J.

(57) **Abstract**

Glass layers and capacitors for use with integrated circuit packages are disclosed. An example integrated circuit (IC) package includes a semiconductor die, a glass layer, and a capacitor electrically coupled to the semiconductor die, at least one side of the capacitor enclosed by the glass layer, the capacitor positioned closer to the glass layer than the semiconductor die is to the glass layer.

## Description

### FIELD OF THE DISCLOSURE

This disclosure relates generally to integrated circuit packages and, more particularly, to glass layers and capacitors for use with integrated circuit packages.

### BACKGROUND

Integrated circuit (IC) chips and/or semiconductor dies are routinely connected to larger circuit boards such as motherboards and other types of printed circuit boards (PCBs) via a package substrate. As IC chips and/or dies reduce in size and interconnect densities increase, alternatives to traditional substrate layers are needed for providing stable transmission of high frequency data signals between different circuitry and/or increased power delivery.

### BRIEF DESCRIPTION OF THE DRAWINGS

FIG. 1 is a cross-sectional view of an example IC package substrate including an example glass layer.
FIG. 2 is a cross-sectional view of another example IC package including an example glass layer constructed in accordance with teachings of this disclosure.
FIG. 3 is a cross-sectional view of another example IC package including an example glass layer constructed in accordance with teachings of this disclosure.
FIG. 4 is a flowchart representative of an example method of manufacturing the example IC package substrates of FIGS. 2 and 3.
FIGS. 5-26 illustrate different stages in an example process of manufacturing the example IC package substrates of FIGS. 2 and 3.
FIG. 27 is a top view of a wafer including dies that may be included in an IC package constructed in accordance with teachings disclosed herein.
FIG. 28 is a cross-sectional side view of an IC device that may be included in an IC package constructed in accordance with teachings disclosed herein.
FIG. 29 is a cross-sectional side view of an IC device assembly that may include an IC package constructed in accordance with teachings disclosed herein.
FIG. 30 is a block diagram of an example electrical device that may include an IC package constructed in accordance with teachings disclosed herein.

In general, the same reference numbers will be used throughout the drawing(s) and accompanying written description to refer to the same or like parts. The figures are not necessarily to scale. Instead, the thickness of the layers or regions may be enlarged in the drawings. Although the figures show layers and regions with clean lines and boundaries, some or all of these lines and/or boundaries may be idealized. In reality, the boundaries and/or lines may be unobservable, blended, and/or irregular.

Notwithstanding the foregoing, in the case of referencing a semiconductor device (e.g., a transistor), a semiconductor die containing a semiconductor device, and/or an integrated circuit (IC) package containing a semiconductor die during fabrication or manufacturing, "above" is not with reference to Earth, but instead is with reference to an underlying substrate on which relevant components are fabricated, assembled, mounted, supported, or otherwise provided. Thus, as used herein and unless otherwise stated or implied from the context, a first component within a semiconductor die (e.g., a transistor or other semiconductor device) is "above" a second component within the semiconductor die when the first component is farther away from a substrate (e.g., a semiconductor wafer) during fabrication/manufacturing than the second component on which the two components are fabricated or otherwise provided. Similarly, unless otherwise stated or implied from the context, a first component within an IC package (e.g., a semiconductor die) is "above" a second component within the IC package during fabrication when the first component is farther away from a printed circuit board (PCB) to which the IC package is to be mounted or attached. It is to be understood that semiconductor devices are often used in orientation different than their orientation during fabrication. Thus, when referring to a semiconductor device (e.g., a transistor), a semiconductor die containing a semiconductor device, and/or an integrated circuit (IC) package containing a semiconductor die during use, the definition of "above" in the preceding paragraph (i.e., the term "above" describes the relationship of two parts relative to Earth) will likely govern based on the usage context.

As used in this patent, stating that any part (e.g., a layer, film, area, region, or plate) is in any way on (e.g., positioned on, located on, disposed on, or formed on, etc.) another part, indicates that the referenced part is either in contact with the other part, or that the referenced part is above the other part with one or more intermediate part(s) located therebetween.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly within the context of the discussion (e.g., within a claim) in which the elements might, for example, otherwise share a same name.

As used herein, "programmable circuitry" is defined to include (i) one or more special purpose electrical circuits (e.g., an application specific circuit (ASIC)) structured to perform specific operation(s) and including one or more semiconductor-based logic devices (e.g., electrical hardware implemented by one or more transistors), and/or (ii) one or more general purpose semiconductor-based electrical circuits programmable with instructions to perform specific functions(s) and/or operation(s) and including one or more semiconductor-based logic devices (e.g., electrical hardware implemented by one or more transistors). Examples of programmable circuitry include programmable microprocessors such as Central Processor Units (CPUs) that may execute first instructions to perform one or more operations and/or functions, Field Programmable Gate Arrays (FPGAs) that may be programmed with second instructions to cause configuration and/or structuring of the FPGAs to instantiate one or more operations and/or functions corresponding to the first instructions, Graphics Processor Units (GPUs) that may execute first instructions to perform one or more operations and/or functions, Digital Signal Processors (DSPs) that may execute first instructions to perform one or more operations and/or functions, XPUs, Network Processing Units (NPUs) one or more microcontrollers that may execute first instructions to perform one or more operations and/or functions and/or integrated circuits such as Application Specific Integrated Circuits (ASICs). For example, an XPU may be implemented by a heterogeneous computing system including multiple types of programmable circuitry (e.g., one or more FPGAs, one or more CPUs, one or more GPUs, one or more NPUs, one or more DSPs, etc., and/or any combination(s) thereof), and orchestration technology (e.g., application programming interface(s) (API(s)) that may assign computing task(s) to whichever one(s) of the multiple types of programmable circuitry is/are suited and available to perform the computing task(s).

As used herein integrated circuit/circuitry is defined as one or more semiconductor packages containing one or more circuit elements such as transistors, capacitors, inductors, resistors, current paths, diodes, etc. For example, an integrated circuit may be implemented as one or more of an ASIC, an FPGA, a chip, a microchip, programmable circuitry, a semiconductor substrate coupling multiple circuit elements, a system on chip (SoC), etc.

### DETAILED DESCRIPTION

Advances in semiconductor packaging architectures result in increased demands on the material properties of a package substrate. For example, as package substrates become thinner to achieve a lower profile, a core of the substrate having a small thickness can be susceptible to warping or bending over time, thereby reducing the functionality of the package substrate. For example, for smaller sized package assemblies (e.g., thin or low profile packages for mobile or other devices), a core of the substrate assembly needs to have improved elasticity and strength. To improve such characteristics of a package substrate, glass layers can be employed. In some examples, package substrates can include a layer or substrate made of glass to restrict or prevent the package assembly from warping or bending from its initial manufactured shape over time. The glass substrate can include, for example, a core layer, an interposer and/or any other layer of a semiconductor package. As used herein, the terms glass substrate, glass core, glass layer, and/or similar terms refer to glass components that do not include epoxy and do not include glass fibers (e.g., do not include an exclude an epoxy-based prepreg layer with glass cloth). In some examples, the glass substrates, glass cores, and/or glass layers disclosed herein may include quartz, fused silica, and/or borosilicate glass. In some examples, as used herein, glass substrates, glass cores, glass layers, and/or similar terms refer to glass components that include at least 20% (by weight) of each of silicon (Si) and oxygen (O). In other examples, glass substrates, glass cores, glass layers, and/or similar terms refer to glass components that include greater amounts of at least one of silicon or oxygen (e.g., at least 25wt%, at least 30wt%, at least 35wt%, at least 40wt%, etc.). In some examples, glass substrates, glass cores, glass layers, and/or similar terms refer to glass components that include at least 5% (by weight) of aluminum (Al). In some examples, a glass substrate, a glass core, and/or a glass layer corresponds to a single piece of glass that extends the full height/thickness of a package core. In some examples, the glass substrate, the glass core, and/or the glass layer has a generally rectangular shape that is substantially coextensive, in plan view, with the layers above and below the core (e.g., substantially coextensive with the build-up layers).

To transmit signals between package components, semiconductor packages often employ transmission lines, such as microstrips, to transmit signals and/or power. As electronic systems become more complex and electrical interfaces in the electrical systems operate at higher frequencies, dense signal processing areas can cause significant crosstalk between adjacent signal paths in such densely packed spaces. Such crosstalk can reduce the performance of the semiconductor substrate.

Examples disclosed herein utilize capacitors provided in and/or on glass layers within package substrates. In some examples, capacitors disclosed herein are provided to increase (e.g., free up) signal routing in adjacent layers (e.g., build-up layers, power lines, patch antenna modules, etc.). In some examples, capacitors disclosed herein may be structured and/or positioned within a glass core of an example integrated circuit (IC) package to improve the power supply of the IC package. For instance, capacitors disclosed herein may be positioned within a glass core and/or between an example semiconductor die and an example build-up layer. As such, capacitors disclosed herein are spaced apart (e.g., insulated) from other conductive components of an example IC package, which provides an increased, overall capacitance for the IC package. Further, some examples disclosed herein include openings in the glass layer for depositing a capacitor therein, which increases the relative surface area of the corresponding capacitor. As such, capacitors disclosed herein cover an increased surface area of the glass layer to increase the available capacitance density of the IC package.

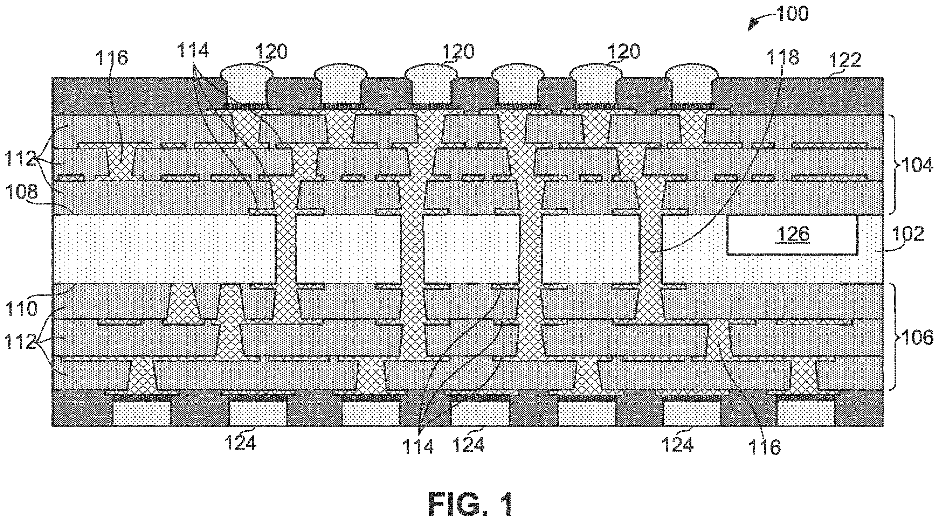

FIG. 1 is a cross-sectional view of an example semiconductor package substrate 100 that may be used to support one or more semiconductor dies within an IC package in accordance with teachings of this disclosure. The package substrate 100 of FIG. 1 includes an example glass layer 102 (e.g., a glass substrate, a glass sheet, a glass panel, etc.) that serves as a core layer (e.g., a glass core) of the substrate 100. The semiconductor package substrate 100 of the illustrated example includes a plurality of build-up layers 104, 106 (e.g., first and second build-up layers 104, 106). Specifically, the first build-up layers 104 are provided on an example first surface 108 of the glass layer 102 and the second build-up layers 106 are provided on an example second surface 110 of the glass layer 102 opposite the first surface 108. The build-up layers 104, 106 of the illustrated example are defined by an alternating pattern of insulation of example dielectric layers 112 and example patterned conductive (e.g., metal, copper, etc.) layers 114. In this example, there are three dielectric layers 112 and three conductive layers 114 in each of the build-up layers 104, 106 (not including the outermost layer of conductive material). However, in other examples, any other suitable number of dielectric layers 112 and conductive layers 114 may be employed. In some examples, the second build-up layers 106 may be omitted such that the glass layer 102 defines an exterior surface of the semiconductor package substrate 100.

The conductive layers 114 in the build-up layers 104, 106 are patterned to define electrical routing or conductive traces that serve as signaling or transmission lines to transfer power and/or signals of information between two or more components (e.g., transistors, capacitors, resistors, backend layers, etc. and/or other circuitry) of an associated IC package. Example electrically conductive (e.g., metal, copper, etc.) vias 116 extend through the dielectric layers 112 to electrically couple different ones of the conductive layers 114 in the different build-up layers 104, 106. Further, as shown in FIG. 1, the glass layer 102 of the illustrated example includes one or more example through glass vias (TGVs) 118 (e.g., copper plated vias) that extend between the opposite surfaces 108, 110 of the glass layer 102 to communicatively and/or electrically couple the conductive layers 114 and associated metal vias 116 within the build-up layers 104, 106 on either side of the glass layer 102. Thus, in this example, the electrical routing or traces defined by the patterning of the conductive layers 114, the conductive vias 116, and the TGVs 118 collectively define electrical interconnects through the semiconductor package substrate 100.

In the illustrated example, the semiconductor package substrate 100 includes a first plurality of example connectors 120 (e.g., solder balls, bumps, contact pads, pins, etc.) on an outer surface 122 of the semiconductor package substrate 100 to electrically and mechanically couple the semiconductor package substrate 100 to a semiconductor die or IC chip and/or any other suitable component (e.g., an interposer). Further, the example semiconductor package substrate 100 includes a second plurality of example solder connectors 124 (e.g., solder balls, bumps, contact pads, pins, etc.) to electrically couple the semiconductor package substrate 100 to a printed circuit board, an interposer and/or any other substrate(s).

Although the glass layer 102 of the example semiconductor package substrate 100 is shown as a central core of the semiconductor package substrate 100, in some examples, the glass layer 102 can be an interposer and/or any other layer of the semiconductor package substrate 100. For example, the glass layer 102 can be used in place of one or more of the dielectric layers 112 of the semiconductor package substrate 100. In some examples, the semiconductor package substrate 100 can include different material(s) including organic materials, silicon, and/or other conventional materials for fabricating package substrates.

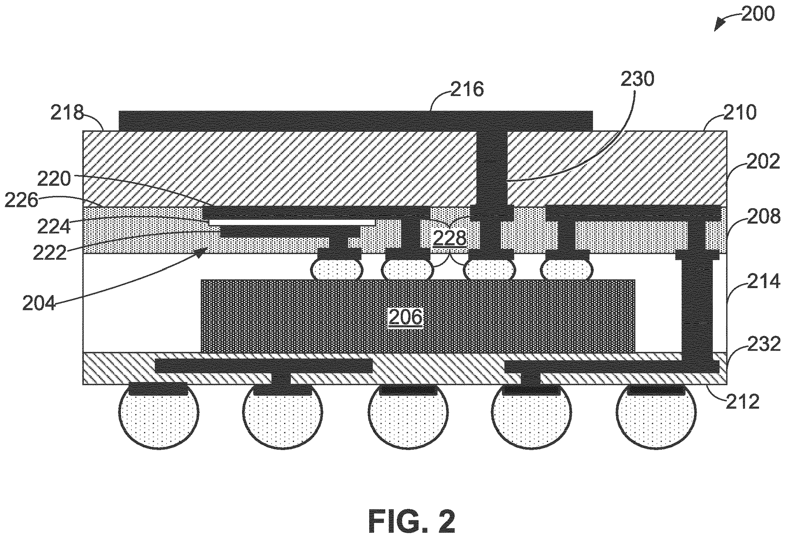

Using glass (e.g., the glass layer 102 of FIG. 1) as a starting core material has a mechanical benefit, an electrical benefit, and a design flexibility benefit over using traditional organic core materials (e.g., epoxy-based prepreg). Furthermore, capacitors can be positioned within glass cores to increase the capacitive density of an associated semiconductor package. As a result, it is possible to incorporate or integrate capacitors directly into a package substrate adjacent a surface of the glass core. More particularly, in the illustrated example, of FIG. 1, an example capacitor 126 is positioned adjacent the first surface 108 of the glass layer 102. In other examples, the capacitor 126 may be adjacent the second surface 110 of the glass layer 102. In other examples, the capacitor 126 may be embedded within a cavity in the glass layer 102 (e.g., on and/or adjacent a surface recessed, internal to, and/or between the outer first and second surfaces 108, 110 of the glass layer 102). In the illustrated example, the capacitor 126 has a height or thickness that is greater than one dielectric layer 112 but less than the thickness of two dielectric layers 112. However, in other examples, the capacitor 126 can be larger or smaller than shown (e.g., equal to or less than the thickness of one dielectric layer 112, equal to or greater than two dielectric layers 112, etc.). Example constructions of capacitors within example package substrates containing glass layers are further detailed in FIGS. 2-26.

FIG. 2 is a cross-sectional view of an example IC package 200 constructed in accordance with examples disclosed herein. The example IC package 200 includes an example glass layer 202 (e.g., a glass core, a glass substrate, a glass sheet, a glass panel, etc.) in a package substrate for the IC package 200. The example IC package 200 further includes an example capacitor 204, an example semiconductor die 206, and a first example build-up layer 208 (e.g., build-up region). The example glass layer 202 and the semiconductor die 206 are separated by at least one dielectric layer (e.g., dielectric material, planarizing dielectric, etc.) in the first build-up layer 208. In this example, there is no build-up layer on the side of the glass layer 202 opposite the semiconductor die 206. As such, the glass layer 202 is adjacent to a first side 210 of the package 200 and the semiconductor die 206 is supported adjacent a second side 212 of the package 200. In this example, the first side 210 of the package 200 opposes the second side 212. In other examples, a second build-up layer may be included adjacent to the first side 210 of the package 200. In some examples, the semiconductor die 206 is at least partially surrounded by a mold 214 (e.g., encapsulant). Further, the example IC package 200 includes an example patch antenna 216 positioned on a first surface 218 of the glass layer 202.

In the illustrated example of FIG. 2, the capacitor 204 is positioned closer to the glass layer 202 than the semiconductor die 206 is to the glass layer 202. In other words, the capacitor 204 may be positioned between the glass layer 202 and the semiconductor die 206. The example capacitor 204 includes a first example electrode 220 (e.g., plate, metal film, layer of metal, etc.) and a second example electrode 222 separated by an example dielectric layer 224. In some examples, the capacitor 204 may be referred to as a metal-insulator-metal (MIM) capacitor. In FIG. 2, the first electrode 220 is positioned closer to the glass layer 202 than the second electrode 222 is to the glass layer 202. In particular, the first electrode 220 is in contact with the glass layer 202. As such, at least one side of the capacitor 204 is enclosed by the glass layer 202. In some examples, the first electrode 220 extends along a second surface 226 (e.g., a planar surface) of the glass layer 202. For example, the first electrode 220 can be at least one of a metal plate, a metal layer, or a metal film that extends along the second surface 226. In FIG. 2, the second surface 226 faces towards the semiconductor die 206. In such examples, the second electrode 222 can extend in a same direction as the first electrode 220.

In FIG. 2, the example capacitor 204 is electrically coupled to the semiconductor die 206. The example package 200 includes example metal interconnects 228 (e.g., solder bumps, contact pads, conductive vias, etc.) extending through the first build-up layer 208 to electrically couple the capacitor 204 to the semiconductor die 206. Further, the example glass layer 202 includes a through glass via (TGV) 230 extending between the second surface 226 and the first surface 218 of the glass layer 202. In this example, the semiconductor die 206 is electrically coupled to the patch antenna 216 via the TGV 230. In some examples, the patch antenna 216 is omitted and other electronic components are supported by the first surface 218 of the glass layer 202 and electrically coupled to the semiconductor die 206 through the TGV 230. In some examples, the package 200 includes a second build-up region 232 on the second side 212 of the package.

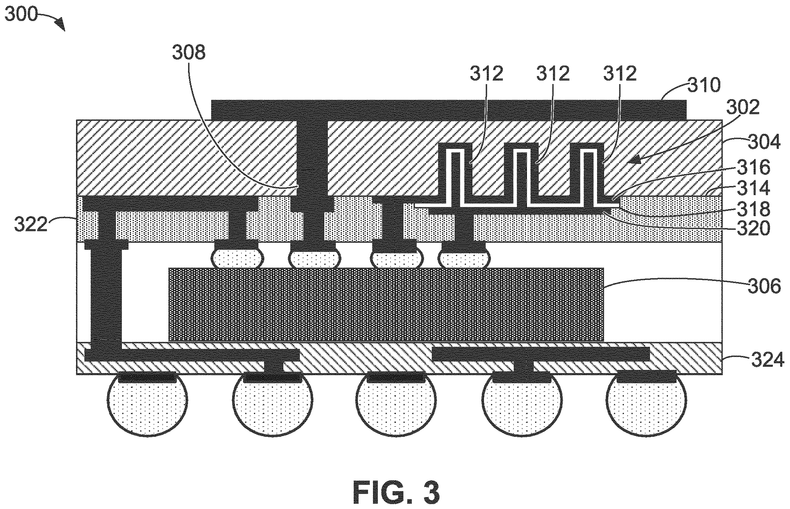

FIG. 3 is a cross-sectional view of an example IC package 300 constructed in accordance with examples disclosed herein. FIG. 3 is similar to the example package 200 of FIG. 2 in that the example package 300 includes an example capacitor 302 positioned between an example glass layer 304 (e.g., a glass substrate, a glass sheet, a glass panel, etc.) and an example semiconductor die 306, the glass layer 304 having an example TGV 308 extending therethrough to electrically couple an example patch antenna 310 to the semiconductor die 306. However, unlike the example package 200 of FIG. 2, the capacitor 302 of FIG. 3 extends at least partially into the glass layer 304. The example glass layer 304 includes cavities 312 in a surface 314 of the glass layer 304. Further, the example cavities 312 are spaced apart from the TGV 308. The example capacitor 302 includes a first layer of metal corresponding to a first electrode 316 of the capacitor 302, a dielectric layer 318 on the first electrode 316, and a second layer of metal corresponding to second electrode 320 of the capacitor 302. In this example, the first electrode 316, the dielectric layer 318, and the second electrode 320 are deposited (at least partially) within the cavities 312. In other words, the example capacitor 302 can include portions (e.g., branches) of the capacitor 302 that extend into the cavities 312 of the glass layer 304. For example, at least a portion of the capacitor 302 can be embedded in the glass layer 304. In some examples, the capacitor 302 may be referred to as a trench capacitor. In some examples, the patch antenna 310 is omitted and other electronic components are supported by the glass layer 304 and electrically coupled to the semiconductor die 306 through the TGV 308. In some examples, the package 300 includes a first example build-up layer 322 positioned between the semiconductor die 306 and the glass layer 304 a second example build-up layer 324 positioned over the semiconductor die 306.

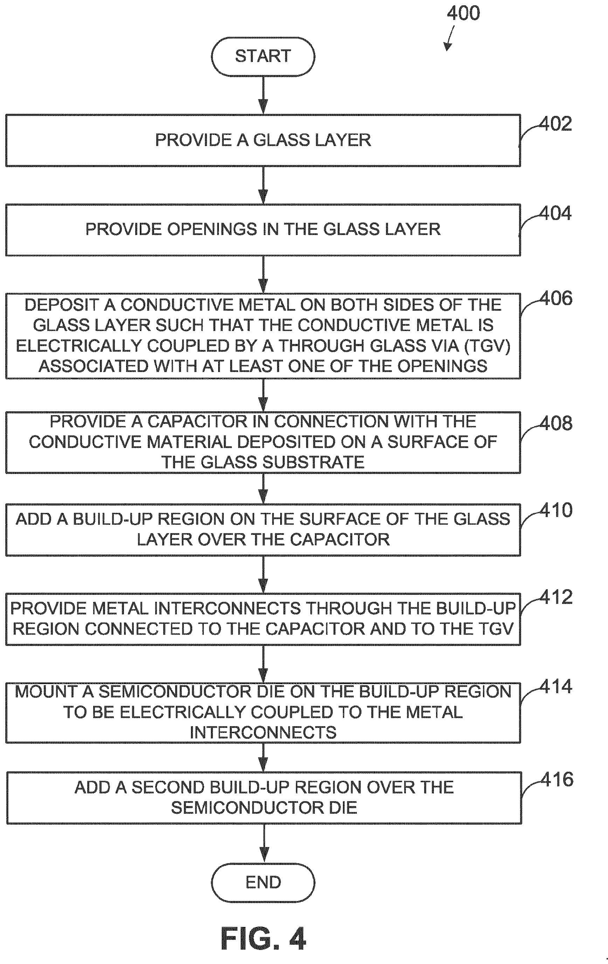

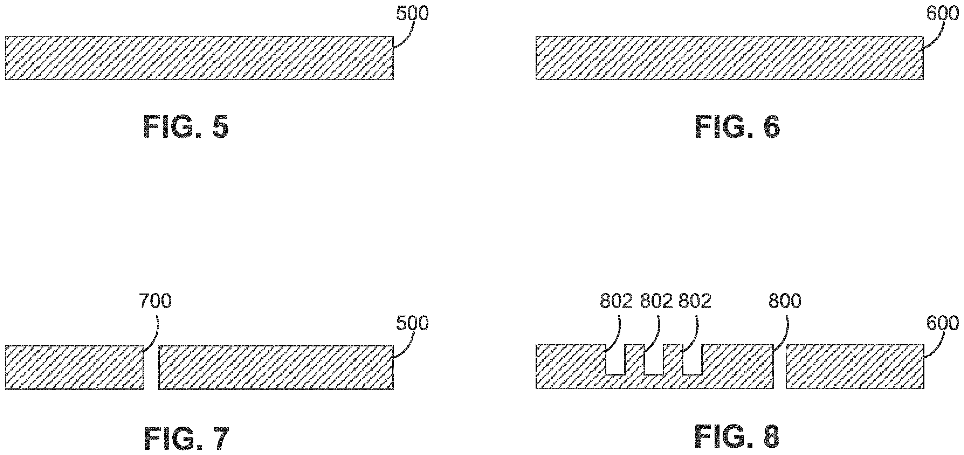

FIG. 4 is a flowchart representative of an example method to produce the example packages 200, 300 of FIGS. 2 and 3. FIGS. 5-26 represent the example packages 200, 300 at various stages during the example process described in FIG. 4. For purposes of explanation, the method to produce the example package 200 of FIG. 2 is described alongside the method to produce the example package 300 of FIG. 3. However, the method to produce the example package 200 can be independent from the method for the example package 300, and vice versa.

Turning to FIG. 4, the example process 400 begins at block 402 at which an example glass layer is provided. As shown in FIGS. 5 and 6, glass layers 500, 600 (e.g., glass substrates, glass sheets, glass panels, etc.) are provided. In this example, the glass layer 500 of FIG. 5 corresponds to the glass layer 202 of FIG. 2 and the glass layer 600 of FIG. 6 corresponds to the glass layer 304 of FIG. 3.

At block 404, example opening(s) are provided in the example glass layer. In some examples, the opening(s) include through holes for TGVs. For example, an example TGV 700 is provided in the glass layer 500, as shown in FIG. 7. Further, an example TGV 800 is provided in the glass layer 600, as shown in FIG. 8. Additionally or alternatively, in some examples, the opening(s) include cavities or trenches that extend into but not through the glass layer. For example, example cavities 802 may be provided in the glass layer 600. In this example, the TGV 700 of FIG. 7 corresponds to the TGV 230 of FIG. 2 and the TGV 800 of FIG. 8 corresponds to the TGV 308 of FIG. 3. Further, the cavities 802 of FIG. 8 correspond to the cavities 312 of FIG. 3.

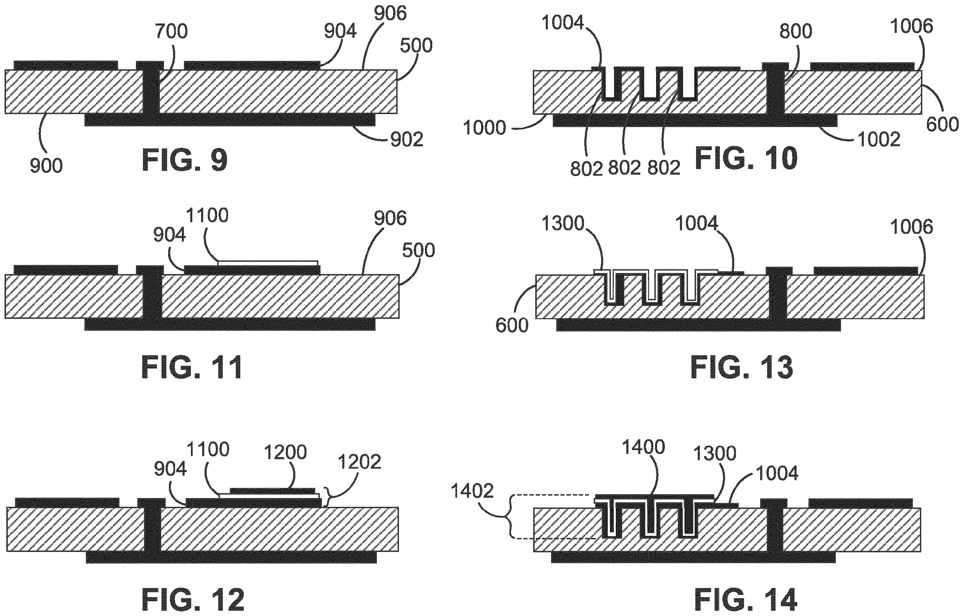

At block 406, an example conductive metal is deposited on both sides of the glass layer and electrically coupled by a TGV associated with at least one of the opening(s). In some examples, the conductive metal can be patterned using any suitable photolithography techniques. In the example of FIG. 9, conductive metal deposited on an example first surface 900 of the glass layer 500 serves as an example patch antenna 902. In this example, the patch antenna 902 corresponds to the patch antenna 216 of FIG. 2. In other examples, the conductive metal on the first surface 900 may serve a different purpose other than a patch antenna. Further, the example patch antenna 902 is electrically coupled to (e.g., in electrical contact with) the TGV 700 and additional conductive metal on a second surface 906 of the glass layer 500 (opposite the first surface 900). In some examples, the additional conductive metal on the second surface 906 corresponds to a first electrode 904 of a capacitor to be provided on the glass layer 500. In this example, the first surface 900 of FIG. 9 corresponds to the first surface 218 of FIG. 2, the second surface 906 of FIG. 9 corresponds to the second surface 226 of FIG. 2, and the first electrode 904 of FIG. 9 corresponds to the first electrode 220 of FIG. 2.

Additionally or alternatively, as shown in FIG. 10, the example glass layer 600 includes an example first surface 1000 on which an example patch antenna 1002 is positioned and that is electrically coupled to additional conductive material on a second surface 1006 of the glass layer 600 by way of a TGV 800. In this example, the patch antenna 1002 corresponds to the patch antenna 310 of FIG. 3. In other examples, the conductive metal on the first surface 1000 may serve a different purpose other than a patch antenna. In some examples, the additional conductive metal on the second surface 1006 corresponds to a first electrode 1004 of a capacitor to be provided on the glass layer 600. In this example, the second surface 1006 of FIG. 10 corresponds to the surface 314 of FIG. 3 and the first electrode 1004 of FIG. 10 corresponds to the first electrode 316 of FIG. 3.

At block 408, an example capacitor is provided in connection with the conductive material deposited on a surface of the glass substrate. That is, as noted above, in some examples, at least some of the conductive material deposited at block 406 corresponds to a first electrode of the capacitor. In other examples, the metal used for the capacitor is deposited during different fabrication processes separate from the conductive metal deposited at block 406. More particularly, as already mentioned above and shown in FIG. 9, a first example electrode 904 is positioned on the second example surface 906 of the glass layer 500. Further, an example dielectric layer 1100 is positioned (e.g., deposited) on the first electrode 904, as shown in FIG. 11. In FIG. 12, a second example electrode 1200 is positioned on the dielectric layer 1100. Thus, the first electrode 904, the dielectric layer 1100, and the second electrode 1200 define an example capacitor 1202. In this example, the first electrode 904 of at least FIGS. 9-12 corresponds to the first electrode 220 of FIG. 2, the dielectric layer 1100 of at least FIGS. 11 and 12 corresponds to the dielectric layer 224 of FIG. 2, the second electrode 1200 of FIG. 12 corresponds to the second electrode 222 of FIG. 2, and the capacitor 1202 of FIG. 12 corresponds to the capacitor 204 of FIG. 2.

Additionally or alternatively, as shown in FIG. 10, a first example electrode 1004 is positioned on the second example surface 1006 of the glass layer 600. In this example, the second example surface 1006 can include (e.g., define) an inner wall of the cavities 802. Further, an example dielectric layer 1300 is positioned (e.g., deposited) on the first electrode 1004, as shown in FIG. 13. In FIG. 14, a second example electrode 1400 is positioned on the dielectric layer 1300. Thus, the first electrode 1004, the dielectric layer 1300, and the second electrode 1400 define an example capacitor 1402. In this example, the first electrode 1004 of at least FIG. 10 corresponds to the first electrode 316 of FIG. 3, the dielectric layer 1300 of FIG. 13 corresponds to the dielectric layer 318 of FIG. 3, the second electrode 1400 of FIG. 14 corresponds to the second electrode 320 of FIG. 3, and the capacitor 1402 of FIG. 14 corresponds to the capacitor 302 of FIG. 3.

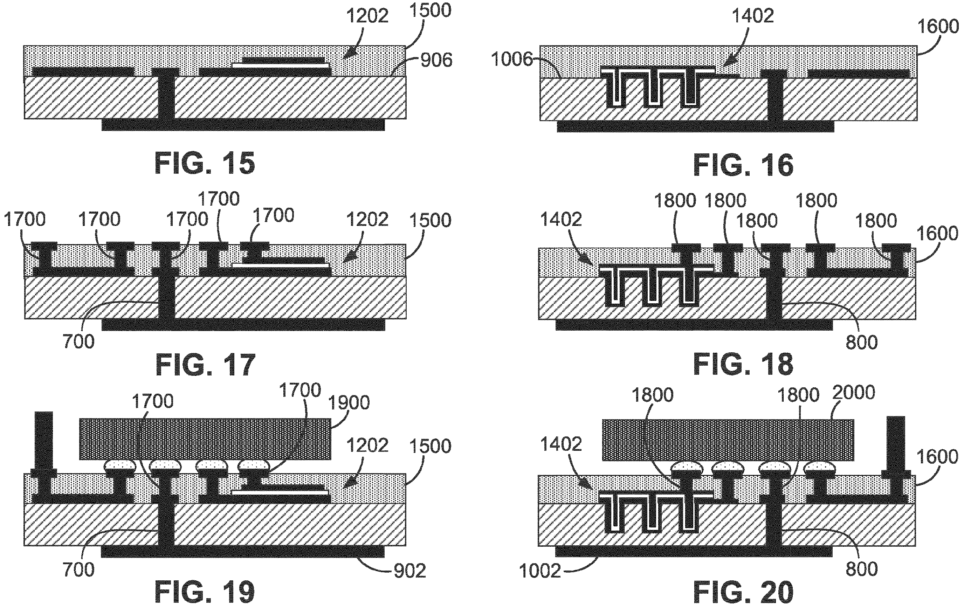

At block 410, an example build-up region is added (e.g., disposed, positioned, etc.) on the surface of the glass core over (e.g., adjacent) the capacitor. As shown in FIG. 15, an example build-up region 1500 is added on the second surface 906 over the capacitor 1202. In this example, the build-up region 1500 of FIG. 15 corresponds to the first build-up layer 208 of FIG. 2. Additionally or alternatively, as shown in FIG. 16, an example build-up region 1600 is added on the second surface 1006 over the capacitor 1402. In some examples, the build-up regions 1500, 1600 include alternating layers of dielectric material and conductive material (as described above in connection with FIG. 1). In this example, the build-up region 1600 of FIG. 16 corresponds to the first build-up layer 322 of FIG. 3.

At block 412, example metal interconnects are provided (e.g., formed) through the build-up region. As shown in FIG. 17, example metal interconnects (e.g., conductive vias, contact pads, etc.) 1700 are formed in the build-up region 1500. The example metal interconnects 1700 are electrically coupled (e.g., connected) to the TGV 700, the capacitor 1202, conductive layers in the build-up region 1500, etc. In this example, the metal interconnects 1700 correspond to the metal interconnects 228 of FIG. 2. Additionally or alternatively, in FIG. 18, example metal interconnects 1800 are formed in the build-up region 1600. The example metal interconnects 1800 are electrically coupled to the TGV 800, the capacitor 1402, conductive layers in the build-up region 1600, etc.

At block 414, an example semiconductor die is mounted (e.g., positioned) on the build-up region to be electrically coupled to the metal interconnects. As shown in FIG. 19, an example semiconductor die 1900 (e.g., corresponding to the example die 206 of FIG. 2) is mounted on the build-up region 1500. The example semiconductor die 1900 is electrically coupled to the capacitor 1202 via the metal interconnects 1700. Further, the example semiconductor die 1900 is electrically coupled to the patch antenna 902 via the metal interconnects 1700 and the TGV 700. Alternatively, in FIG. 20, an example semiconductor die 2000 (e.g., corresponding to the example die 306 of FIG. 3) is mounted on the build-up region 1600. The example semiconductor die 2000 is electrically coupled to the capacitor 1402 via the metal interconnects 1800. Further, the example semiconductor die 2000 is electrically coupled to the patch antenna 1002 via the metal interconnects 1800 and the TGV 800.

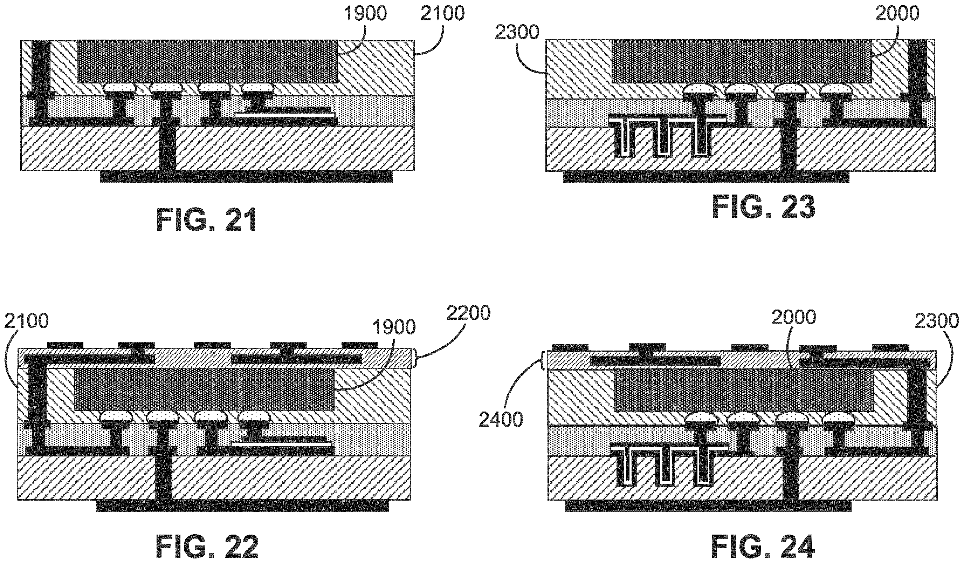

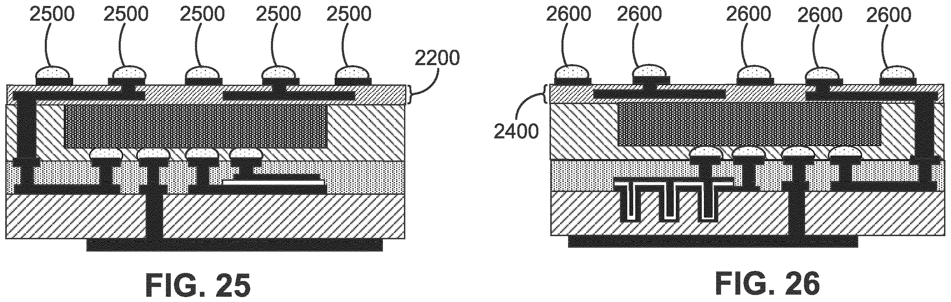

At block 416, an example second build-up region can be added over the semiconductor die. In some examples, the second build-up region is added after the example semiconductor die is encapsulated in an example mold compound. As shown in FIG. 21, an example encapsulant 2100 surrounds the semiconductor die 1900. Further, as shown in FIG. 22, an example build-up region 2200 is added on the semiconductor die 1900 and the encapsulant 2100. In this example, the build-up region 2200 of FIG. 22 corresponds to the second build-up region 232 of FIG. 2. Alternatively, in FIG. 23, an example encapsulant 2300 surrounds the semiconductor die 2000. Further, as shown in FIG. 24, an example build-up region 2400 is added on the semiconductor die 2000 and the encapsulant 2300. In some examples, the build-up region 2200 can include solder joints 2500 (FIG. 25) and the build-up region 2400 can include solder joints 2600 (FIG. 26) to facilitate the electrical coupling of the completed packages to a circuit board. In this example, the build-up region 2400 of FIG. 24 corresponds to the build-up region 324 of FIG. 3.

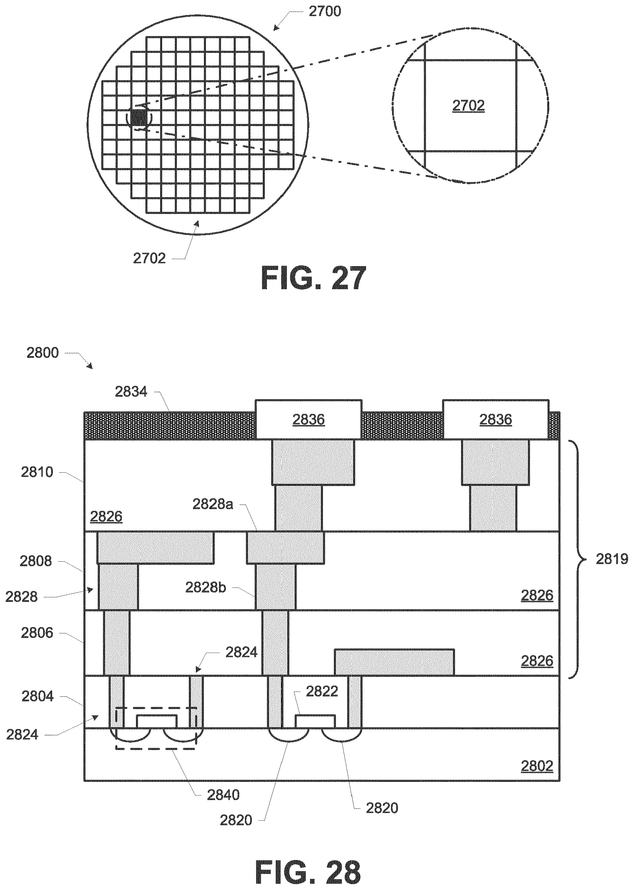

The example IC packages 200, 300 disclosed herein may be included in any suitable electronic component. FIGS. 27-30 illustrate various examples of apparatus that may include or be included in the IC packages 200, 300 disclosed herein.

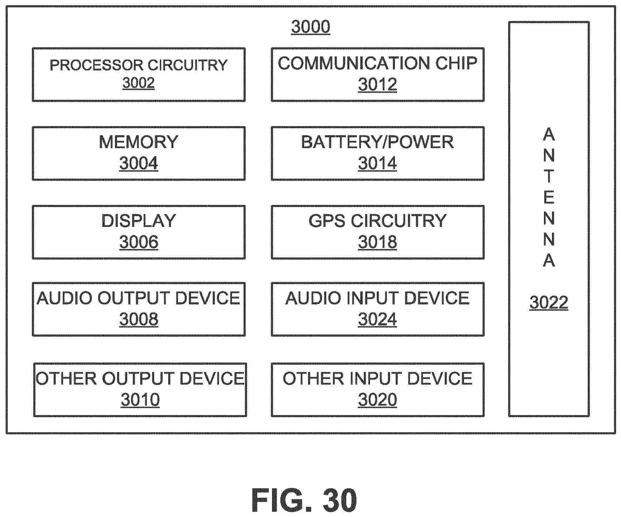

FIG. 27 is a top view of an example wafer 2700 and dies 2702 that may be included in the IC packages 200, 300 (e.g., as any suitable ones of the dies 206, 306). The wafer 2700 may be composed of semiconductor material and may include one or more dies 2702 having circuitry. Some or all of the dies 2702 may be a repeating unit of a semiconductor product. After the fabrication of the semiconductor product is complete, the wafer 2700 may undergo a singulation process in which the dies 2702 are separated from one another to provide discrete "chips." The die 2702 may include one or more transistors (e.g., some of the transistors 2840 of FIG. 28, discussed below), supporting circuitry to route electrical signals to the transistors, passive components (e.g., traces, resistors, capacitors, inductors, and/or other circuitry), and/or any other components. In some examples, the die 2702 may include and/or implement a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuitry. Multiple ones of these devices may be combined on a single die 2702. For example, a memory array formed by multiple memory circuits may be formed on a same die 2702 as programmable circuitry (e.g., the processor circuitry 3002 of FIG. 30) or other logic circuitry. Such memory may store information for use by the programmable circuitry. The example IC packages 200, 300 disclosed herein may be manufactured using a die-to-wafer assembly technique in which some dies 206, 306 are attached to a wafer 2700 that include others of the dies 206, 306, and the wafer 2700 is subsequently singulated.

FIG. 28 is a cross-sectional side view of an example IC device 2800 that may be included in the example IC packages 200, 300 (e.g., in any one of the dies 206, 306). One or more of the IC devices 2800 may be included in one or more dies 2702 (FIG. 27). The IC device 2800 may be formed on an example die substrate 2802 (e.g., the wafer 2700 of FIG. 27) and may be included in a die (e.g., the die 2702 of FIG. 27). The die substrate 2802 may be a semiconductor substrate composed of semiconductor material systems including, for example, n-type or p-type materials systems (or a combination of both). The die substrate 2802 may include, for example, a crystalline substrate formed using a bulk silicon or a silicon-on-insulator (SOI) substructure. In some examples, the die substrate 2802 may be formed using alternative materials, which may or may not be combined with silicon, that include but are not limited to germanium, indium antimonide, lead telluride, indium arsenide, indium phosphide, gallium arsenide, or gallium antimonide. Further materials classified as group II-VI, III-V, or IV may also be used to form the die substrate 2802. Although a few examples of materials from which the die substrate 2802 may be formed are described here, any material that may serve as a foundation for an IC device 2800 may be used. The die substrate 2802 may be part of a singulated die (e.g., the dies 2702 of FIG. 27) or a wafer (e.g., the wafer 2700 of FIG. 27).

The IC device 2800 may include one or more example device layers 2804 disposed on or above the die substrate 2802. The device layer 2804 may include features of one or more example transistors 2840 (e.g., metal oxide semiconductor field-effect transistors (MOSFETs)) formed on the die substrate 2802. The device layer 2804 may include, for example, one or more example source and/or drain (S/D) regions 2820, an example gate 2822 to control current flow between the S/D regions 2820, and one or more example S/D contacts 2824 to route electrical signals to/from the S/D regions 2820. The transistors 2840 may include additional features not depicted for the sake of clarity such as, for example, device isolation regions, gate contacts, and the like. The transistors 2840 are not limited to the type and configuration depicted in FIG. 28 and may include a wide variety of other types and/or configurations such as, for example, planar transistors, non-planar transistors, or a combination of both. Non-planar transistors may include FinFET transistors such as for example, double-gate transistors, tri-gate transistors, wrap-around gate transistor, and/or all-around gate transistors, such as nanoribbon and/or nanowire transistors.

Some or all of the transistors 2840 may include an example gate 2822 formed of at least two layers including a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some examples, an annealing process may be carried out on the gate dielectric to improve its quality when a high-k material is used.

The gate electrode may be formed on the gate dielectric and may include at least one p-type work function metal or n-type work function metal, depending on whether the transistor 2840 is to be a p-type metal oxide semiconductor (PMOS) or an n-type metal oxide semiconductor (NMOS) transistor. In some implementations, the gate electrode may include a stack of two or more metal layers, where one or more metal layers are work function metal layers and at least one metal layer is a fill metal layer. Further metal layers may be included for other purposes, such as for example a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some examples, when viewed as a cross-section of the transistor 2840 along the source-channel-drain direction, the gate electrode may include a U-shaped structure that includes a bottom portion substantially parallel to the surface of the die substrate 2802 and two sidewall portions that are substantially perpendicular to the top surface of the die substrate 2802. In other examples, at least one of the metal layers that form the gate electrode may be a planar layer that is substantially parallel to the top surface of the die substrate 2802 and does not include sidewall portions substantially perpendicular to the top surface of the die substrate 2802. In other examples, the gate electrode may include a combination of U-shaped structures and planar, non-U-shaped structures. For example, the gate electrode may include one or more U-shaped metal layers formed atop one or more planar, non-U-shaped layers.

In some examples, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers include deposition and etching process steps. In some examples, a plurality of spacer pairs may be used; for instance, two pairs, three pairs, or four pairs of sidewall spacers may be formed on opposing sides of the gate stack.

The S/D regions 2820 may be formed within the die substrate 2802 adjacent to the gate 2822 of respective ones of the transistors 2840. The S/D regions 2820 may be formed using an implantation/diffusion process or an etching/deposition process, for example. In the former process, dopants such as boron, aluminum, antimony, phosphorous, or arsenic may be ion-implanted into the die substrate 2802 to form the S/D regions 2820. An annealing process that activates the dopants and causes the dopants to diffuse farther into the die substrate 2802 may follow the ion-implantation process. In the latter process, the die substrate 2802 may first be etched to form recesses at the locations of the S/D regions 2820. An epitaxial deposition process may then be carried out to fill the recesses with material that is used to fabricate the S/D regions 2820. In some implementations, the S/D regions 2820 may be fabricated using a silicon alloy such as silicon germanium or silicon carbide. In some examples, the epitaxially deposited silicon alloy may be doped in situ with dopants such as boron, arsenic, or phosphorous. In some examples, the S/D regions 2820 may be formed using one or more alternate semiconductor materials such as germanium or a group III-V material or alloy. In further examples, one or more layers of metal and/or metal alloys may be used to form the S/D regions 2820.

Electrical signals, such as power and/or input/output (I/O) signals, may be routed to and/or from the devices (e.g., transistors 2840) of the device layer 2804 through one or more example interconnect layers disposed on the device layer 2804 (illustrated in FIG. 28 as interconnect layers 2806-2810). For example, electrically conductive features of the device layer 2804 (e.g., the gate 2822 and the S/D contacts 2824) may be electrically coupled with example interconnect structures 2828 of the interconnect layers 2806-2810. The one or more interconnect layers 2806-2810 may form an example metallization stack (also referred to as an "ILD stack") 2819 of the IC device 2800.

The interconnect structures 2828 may be arranged within the interconnect layers 2806-2810 to route electrical signals according to a wide variety of designs (in particular, the arrangement is not limited to the particular configuration of interconnect structures 2828 depicted in FIG. 28). Although a particular number of interconnect layers 2806-2810 is depicted in FIG. 28, examples of the present disclosure include IC devices having more or fewer interconnect layers than depicted.

In some examples, the interconnect structures 2828 may include example lines 2828a and/or example vias 2828b filled with an electrically conductive material such as a metal. The lines 2828a may be arranged to route electrical signals in a direction of a plane that is substantially parallel with a surface of the die substrate 2802 upon which the device layer 2804 is formed. For example, the lines 2828a may route electrical signals in a direction in and out of the page from the perspective of FIG. 28. The vias 2828b may be arranged to route electrical signals in a direction of a plane that is substantially perpendicular to the surface of the die substrate 2802 upon which the device layer 2804 is formed. In some examples, the vias 2828b may electrically couple lines 2828a of different interconnect layers 2806-2810 together.

The interconnect layers 2806-2810 may include an example dielectric material 2826 disposed between the interconnect structures 2828, as shown in FIG. 28. In some examples, the dielectric material 2826 disposed between the interconnect structures 2828 in different ones of the interconnect layers 2806-2810 may have different compositions. In other examples, the composition of the dielectric material 2826 between different interconnect layers 2806-2810 may be the same.

A first interconnect layer 2806 (referred to as Metal 1 or "M1") may be formed directly on the device layer 2804. In some examples, the first interconnect layer 2806 may include lines 2828a and/or vias 2828b, as shown. The lines 2828a of the first interconnect layer 2806 may be coupled with contacts (e.g., the S/D contacts 2824) of the device layer 2804.

A second interconnect layer 2808 (referred to as Metal 2 or "M2") may be formed directly on the first interconnect layer 2806. In some examples, the second interconnect layer 2808 may include vias 2828b to couple the lines 2828a of the second interconnect layer 2808 with the lines 2828a of the first interconnect layer 2806. Although the lines 2828a and the vias 2828b are structurally delineated with a line within each interconnect layer (e.g., within the second interconnect layer 2808) for the sake of clarity, the lines 2828a and the vias 2828b may be structurally and/or materially contiguous (e.g., simultaneously filled during a dual-damascene process) in some examples.

A third interconnect layer 2810 (referred to as Metal 3 or "M3") (and additional interconnect layers, as desired) may be formed in succession on the second interconnect layer 2808 according to similar techniques and configurations described in connection with the second interconnect layer 2808 and/or the first interconnect layer 2806. In some examples, the interconnect layers that are "higher up" in the metallization stack 2819 in the IC device 2800 (i.e., further away from the device layer 2804) may be thicker.

The IC device 2800 may include an example solder resist material 2834 (e.g., polyimide or similar material) and one or more example conductive contacts 2836 formed on the interconnect layers 2806-2810. In FIG. 28, the conductive contacts 2836 are illustrated as taking the form of bond pads. The conductive contacts 2836 may be electrically coupled with the interconnect structures 2828 and configured to route the electrical signals of the transistor(s) 2840 to other external devices. For example, solder bonds may be formed on the one or more conductive contacts 2836 to mechanically and/or electrically couple a chip including the IC device 2800 with another component (e.g., a circuit board). The IC device 2800 may include additional or alternate structures to route the electrical signals from the interconnect layers 2806-2810; for example, the conductive contacts 2836 may include other analogous features (e.g., posts) that route the electrical signals to external components.

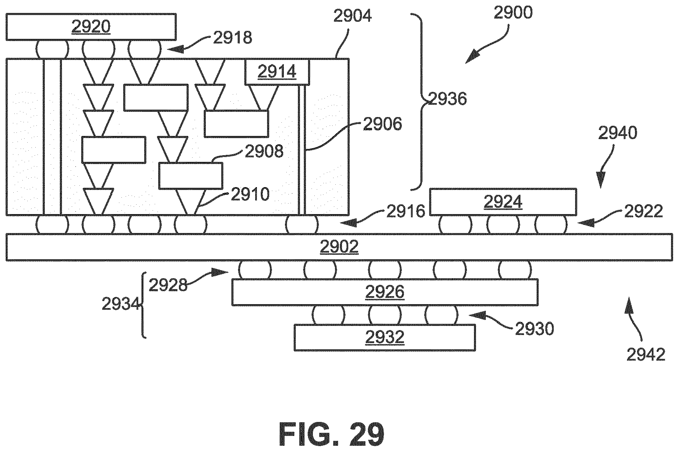

FIG. 29 is a cross-sectional side view of an example IC device assembly 2900 that may include the IC packages 200, 300 disclosed herein. In some examples, the IC device assembly corresponds to the IC packages 200, 300. The IC device assembly 2900 includes a number of components disposed on an example circuit board 2902 (which may be, for example, a motherboard). The IC device assembly 2900 includes components disposed on an example first face 2940 of the circuit board 2902 and an example opposing second face 2942 of the circuit board 2902. Any of the IC packages discussed herein with reference to the IC device assembly 2900 may take the form of the example IC packages 200, 300.

In some examples, the circuit board 2902 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2902. In other examples, the circuit board 2902 may be a non-PCB substrate.

The IC device assembly 2900 illustrated in FIG. 29 includes an example package-on-interposer structure 2936 coupled to the first face 2940 of the circuit board 2902 by example coupling components 2916. The coupling components 2916 may electrically and mechanically couple the package-on-interposer structure 2936 to the circuit board 2902, and may include solder balls (as shown in FIG. 29), male and female portions of a socket, an adhesive, an underfill material, and/or any other suitable electrical, chemical, and/or mechanical coupling structure.

The package-on-interposer structure 2936 may include an example IC package 2920 coupled to an example interposer 2904 by example coupling components 2918. The coupling components 2918 may take any suitable form for the application, such as the forms discussed above with reference to the coupling components 2916. Although a single IC package 2920 is shown in FIG. 29, multiple IC packages may be coupled to the interposer 2904. Additionally or alternatively, in some examples, additional interposers may be coupled to the interposer 2904. The interposer 2904 may provide an intervening substrate used to bridge the circuit board 2902 and the IC package 2920. The IC package 2920 may be or include, for example, a die (the die 2702 of FIG. 27), an IC device (e.g., the IC device 2800 of FIG. 28), and/or any other suitable component(s). Generally, the interposer 2904 may spread a connection to a wider pitch or reroute a connection to a different connection. For example, the interposer 2904 may couple the IC package 2920 (e.g., a die) to a set of BGA conductive contacts of the coupling components 2916 for coupling to the circuit board 2902. In the example illustrated in FIG. 29, the IC package 2920 and the circuit board 2902 are attached to opposing sides of the interposer 2904. In other examples, the IC package 2920 and the circuit board 2902 may be attached to a same side of the interposer 2904. In some examples, three or more components may be interconnected by way of the interposer 2904.

In some examples, the interposer 2904 may be formed as a PCB, including multiple metal layers separated from one another by layers of dielectric material and interconnected by electrically conductive vias. In some examples, the interposer 2904 may be formed of an epoxy resin, a fiberglass-reinforced epoxy resin, an epoxy resin with inorganic fillers, a ceramic material, or a polymer material such as polyimide. In some examples, the interposer 2904 may be formed of alternate rigid or flexible materials that may include the same materials described above for use in a semiconductor substrate, such as silicon, germanium, and other group III-V and group IV materials. The interposer 2904 may include example metal interconnects 2908 and example vias 2910, including but not limited to example through-silicon vias (TSVs) 2906. The interposer 2904 may further include example embedded devices 2914, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 2904. The package-on-interposer structure 2936 may take the form of any of the package-on-interposer structures known in the art.

The IC device assembly 2900 may include an example IC package 2924 coupled to the first face 2940 of the circuit board 2902 by example coupling components 2922. The coupling components 2922 may take the form of any of the examples discussed above with reference to the coupling components 2916, and the IC package 2924 may take the form of any of the examples discussed above with reference to the IC package 2920.

The IC device assembly 2900 illustrated in FIG. 29 includes an example package-on-package structure 2934 coupled to the second face 2942 of the circuit board 2902 by coupling components 2928. The package-on-package structure 2934 may include a first example IC package 2926 and a second example IC package 2932 coupled together by example coupling components 2930 such that the first IC package 2926 is disposed between the circuit board 2902 and the second IC package 2932. The coupling components 2928, 2930 may take the form of any of the examples of the coupling components 2916 discussed above, and the IC packages 2926, 2932 may take the form of any of the examples of the IC package 2920 discussed above.

FIG. 30 is a block diagram of an example electrical device 3000 that may include one or more of the example IC packages 200, 300. For example, any suitable ones of the components of the electrical device 3000 may include one or more of the device assemblies 2900, IC devices 2800, or dies 2702 disclosed herein, and may be arranged in the example IC packages 200, 300. A number of components are illustrated in FIG. 30 as included in the electrical device 3000, but any one or more of these components may be omitted or duplicated, as suitable for the application. In some examples, some or all of the components included in the electrical device 3000 may be attached to one or more motherboards. In some examples, some or all of these components are fabricated onto a single system-on-a-chip (SoC) die.

Additionally, in some examples, the electrical device 3000 may not include one or more of the components illustrated in FIG. 30, but the electrical device 3000 may include interface circuitry for coupling to the one or more components. For example, the electrical device 3000 may not include an example display 3006, but may include display interface circuitry (e.g., a connector and driver circuitry) to which the display 3006 may be coupled. In some examples, the electrical device 3000 may not include an example audio input device 3024 (e.g., microphone) or an example audio output device 3008 (e.g., a speaker, a headset, earbuds, etc.), but may include audio input or output device interface circuitry (e.g., connectors and supporting circuitry) to which the audio input device 3024 or the audio output device 3008 may be coupled.

The electrical device 3000 may include example programmable or processor circuitry 3002 (e.g., one or more processing devices). The processor circuitry 3002 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

The electrical device 3000 may include an example memory 3004, which may itself include one or more memory devices such as volatile memory (e.g., dynamic random access memory (DRAM)), nonvolatile memory (e.g., read-only memory (ROM)), flash memory, solid state memory, and/or a hard drive. In some examples, the memory 3004 may include memory that shares a die with the programmable circuitry 3002. This memory may be used as cache memory and may include embedded dynamic random access memory (eDRAM) or spin transfer torque magnetic random access memory (STT-MRAM).

In some examples, the electrical device 3000 may include an example communication chip 3012 (e.g., one or more communication chips). For example, the communication chip 3012 may be configured for managing wireless communications for the transfer of data to and from the electrical device 3000. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some examples they might not.

The communication chip 3012 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (LTMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 3012 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 3012 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 3012 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 3012 may operate in accordance with other wireless protocols in other examples. The electrical device 3000 may include an example antenna 3022 to facilitate wireless communications and/or to receive other wireless communications (such as AM or FM radio transmissions).

In some examples, the communication chip 3012 may manage wired communications, such as electrical, optical, or any other suitable communication protocols (e.g., the Ethernet). As noted above, the communication chip 3012 may include multiple communication chips. For instance, a first communication chip 3012 may be dedicated to shorter-range wireless communications such as Wi-Fi or Bluetooth, and a second communication chip 3012 may be dedicated to longer-range wireless communications such as global positioning system (GPS), EDGE, GPRS, CDMA, WiMAX, LTE, EV-DO, or others. In some examples, a first communication chip 3012 may be dedicated to wireless communications, and a second communication chip 3012 may be dedicated to wired communications.

The electrical device 3000 may include example battery/power circuitry 3014. The battery/power circuitry 3014 may include one or more energy storage devices (e.g., batteries or capacitors) and/or circuitry for coupling components of the electrical device 3000 to an energy source separate from the electrical device 3000 (e.g., AC line power).

The electrical device 3000 may include the display 3006 (or corresponding interface circuitry, as discussed above). The display 3006 may include any visual indicators, such as a heads-up display, a computer monitor, a projector, a touchscreen display, a liquid crystal display (LCD), a light-emitting diode display, or a flat panel display.

The electrical device 3000 may include the audio output device 3008 (or corresponding interface circuitry, as discussed above). The audio output device 3008 may include any device that generates an audible indicator, such as speakers, headsets, or earbuds.

The electrical device 3000 may include the audio input device 3024 (or corresponding interface circuitry, as discussed above). The audio input device 3024 may include any device that generates a signal representative of a sound, such as microphones, microphone arrays, or digital instruments (e.g., instruments having a musical instrument digital interface (MIDI) output).

The electrical device 3000 may include example GPS circuitry 3018. The GPS circuitry 3018 may be in communication with a satellite-based system and may receive a location of the electrical device 3000, as known in the art.

The electrical device 3000 may include any other example output device 3010 (or corresponding interface circuitry, as discussed above). Examples of the other output device 3010 may include an audio codec, a video codec, a printer, a wired or wireless transmitter for providing information to other devices, and/or an additional storage device.

The electrical device 3000 may include any other example input device 3020 (or corresponding interface circuitry, as discussed above). Examples of the other input device 3020 may include an accelerometer, a gyroscope, a compass, an image capture device, a keyboard, a cursor control device such as a mouse, a stylus, a touchpad, a bar code reader, a Quick Response (QR) code reader, any sensor, and/or a radio frequency identification (RFID) reader.

The electrical device 3000 may have any desired form factor, such as, for example, a hand-held or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server or other networked computing component, a printer, a scanner, a monitor, a set-top box, an entertainment control unit, a vehicle control unit, a digital camera, a digital video recorder, or a wearable electrical device (e.g., a smartwatch, a ring, googles, a headset, glasses, etc.). In some examples, the electrical device 3000 may be any other electronic device that processes data.

From the foregoing, it will be appreciated that example systems, apparatus, articles of manufacture, and methods have been disclosed that enable capacitors to be provided in and/or on glass layers in package substrates to increase signal routing in adjacent layers and/or to improve the power supply for an associated IC package.

Example 1 includes an integrated circuit (IC) package comprising a semiconductor die, a glass layer, and a capacitor electrically coupled to the semiconductor die, at least one side of the capacitor enclosed by the glass layer, the capacitor positioned closer to the glass layer than the semiconductor die is to the glass layer.

Example 2 includes the IC package of example 1, further including a dielectric material separating the glass layer and the semiconductor die.

Example 3 includes the IC package of example 1, wherein the glass layer includes a through glass via (TGV) extending between first and second surfaces of the glass layer, the first surface facing towards the semiconductor die, the semiconductor die electrically coupled to the TGV.

Example 4 includes the IC package of example 3, further including a patch antenna on the second surface, the patch antenna electrically coupled to the semiconductor die via the TGV.

Example 5 includes the IC package of example 1, wherein the capacitor is a metal-insulator-metal (MIM) capacitor.

Example 6 includes the IC package of example 5, wherein the MIM capacitor includes a first plate and a second plate, the first plate positioned closer to the glass layer than the second plate is to the glass layer.

Example 7 includes the IC package of example 6, wherein the MIM capacitor further includes a dielectric layer separating the first plate and the second plate.

Example 8 includes the IC package of example 6, wherein the first plate is to contact a surface of the glass layer.

Example 9 includes the IC package of example 8, wherein the first plate extends along the surface of the glass layer.

Example 10 includes the IC package of example 1, wherein the capacitor is a trench capacitor.

Example 11 includes the IC package of example 10, wherein the trench capacitor includes at least one branch embedded in the glass layer, the at least one branch including a first electrode and a second electrode, the first electrode surrounding the second electrode, the first and second electrodes separated by a dielectric.

Example 12 includes the IC package of example 11, wherein the at least one branch is positioned in a cavity of the glass layer.

Example 13 includes an integrated circuit (IC) package comprising a package substrate having a glass core, the package substrate supporting a semiconductor die, and first and second electrodes separated by a dielectric material, the first electrode in contact with the glass core, the second electrode positioned closer to the semiconductor die than the first electrode is to the semiconductor die, the first and second electrodes at least partially enclosed by a surface of the glass core, the first and second electrodes electrically coupled to the semiconductor die.

Example 14 includes the IC package of example 13, wherein the glass core includes a cavity on the surface of the glass core, portions of at least one of the first or second electrodes extending into the cavities.

Example 15 includes the IC package of example 13, wherein the first electrode includes a first metal film, the first metal film extending along the surface of the glass core, and the second electrode includes a second metal film, the second metal film extending in a same direction as the first metal film.

Example 16 includes a method for forming a semiconductor package comprising providing a through glass via (TGV) extending between first and second surfaces of a glass substrate, the first surface opposite the second surface, positioning a capacitor on the first surface of the glass substrate, adding a dielectric material, the capacitor to be enclosed between the glass substrate and the dielectric material, and mounting a semiconductor die to the dielectric material, the semiconductor die electrically coupled to the capacitor.

Example 17 includes the method of example 16, further including positioning a patch antenna on the first surface of the glass substrate, the semiconductor die and the patch antenna electrically coupled via the TGV.

Example 18 includes the method of example 16, further including depositing a first layer of metal on the glass substrate, the first layer of metal corresponding to a first electrode of the capacitor, depositing a dielectric layer on the first layer of metal, and depositing a second layer of metal on the glass substrate, the second layer of metal corresponding to a second electrode of the capacitor.

Example 19 includes the method of example 18, further including providing a cavity in the glass substrate, the cavity spaced apart from the TGV, the first layer of metal, the dielectric layer, and the second layer of metal deposited within the cavity.

Example 20 includes the method of example 18, wherein the first layer of metal, the dielectric layer, and the second layer of metal are deposited across a planar surface of the glass substrate, the planar surface corresponding to the first surface of the glass substrate.

The following claims are hereby incorporated into this Detailed Description by this reference. Although certain example systems, apparatus, articles of manufacture, and methods have been disclosed herein, the scope of coverage of this patent is not limited thereto. On the contrary, this patent covers all systems, apparatus, articles of manufacture, and methods fairly falling within the scope of the claims of this patent.

## Claims

1. An integrated circuit (IC) package comprising:
a semiconductor die;
a glass layer; and
a capacitor electrically coupled to the semiconductor die, at least one side of the capacitor enclosed by the glass layer, the capacitor positioned closer to the glass layer than the semiconductor die is to the glass layer.

2. The IC package of claim 1, further including a dielectric material separating the glass layer and the semiconductor die.

3. The IC package of any one of claims 1 or 2, wherein the glass layer includes a through glass via (TGV) extending between first and second surfaces of the glass layer, the first surface facing towards the semiconductor die, the semiconductor die electrically coupled to the TGV.

4. The IC package of any one of claims 1, 2, or 3, further including a patch antenna on the second surface, the patch antenna electrically coupled to the semiconductor die via the TGV.

5. The IC package of any one of claims 1-4, wherein the capacitor is a metal-insulator-metal (MIM) capacitor.

6. The IC package of claim 5, wherein the MIM capacitor includes a first plate and a second plate, the first plate positioned closer to the glass layer than the second plate is to the glass layer.

7. The IC package of claim 6, wherein the MIM capacitor further includes a dielectric layer separating the first plate and the second plate.

8. The IC package of claims any one of 6 or 7, wherein the first plate is to contact a surface of the glass layer.

9. The IC package of any one of claims 6, 7, or 8, wherein the first plate extends along the surface of the glass layer.

10. The IC package of any one of claims 1-4, wherein the capacitor is a trench capacitor.

11. The IC package of claim 10, wherein the trench capacitor includes at least one branch embedded in the glass layer, the at least one branch including a first electrode and a second electrode, the first electrode surrounding the second electrode, the first and second electrodes separated by a dielectric.

12. The IC package of any one of claims 10 or 11, wherein the at least one branch is positioned in a cavity of the glass layer.

13. A method for forming a semiconductor package comprising:
providing a through glass via (TGV) extending between first and second surfaces of a glass substrate, the first surface opposite the second surface;
positioning a capacitor on the first surface of the glass substrate;
adding a dielectric material, the capacitor to be enclosed between the glass substrate and the dielectric material; and
mounting a semiconductor die to the dielectric material, the semiconductor die electrically coupled to the capacitor.

14. The method of claim 13, further including positioning a patch antenna on the first surface of the glass substrate, the semiconductor die and the patch antenna electrically coupled via the TGV.

15. The method of any one of claims 13 or 14, further including:
depositing a first layer of metal on the glass substrate, the first layer of metal corresponding to a first electrode of the capacitor;
depositing a dielectric layer on the first layer of metal; and
depositing a second layer of metal on the glass substrate, the second layer of metal corresponding to a second electrode of the capacitor.
